# EUROPÄISCHE PATENTSCHRIFT

(11) **EP 2 100 179 B1**
(45) Veröffentlichungstag und Bekanntmachung des Hinweises auf die Patenterteilung: **06.11.2013**
(21) Anmeldenummer: 07856077.8
(22) Anmeldetag: 11.12.2007
(51) Int. Cl.: G02B 26/08, B81B 3/00, B81C 1/00

(54) **MIKROSPIEGEL-AKTUATOR MIT KAPSELUNGSMÖGLICHKEIT SOWIE VERFAHREN ZUR HERSTELLUNG**
MICROMIRROR ACTUATOR WITH ENCAPSULATION POSSIBILITY AND METHOD FOR PRODUCTION THEREOF
ACTIONNEUR À MICRO-MIROIR PRÉSENTANT UNE POSSIBILITÉ D'ENCAPSULAGE ET PROCÉDÉ DE FABRICATION

(30) Priorität: 12.12.2006 DE 102006058563
(43) Veröffentlichungstag der Anmeldung: 16.09.2009
(73) Patentinhaber: Fraunhofer-Gesellschaft zur Förderung der angewandten Forschung e.V., 80686 München (DE)
(72) Erfinder: HOFMANN, Ulrich, 25524 Itzehoe (DE); OLDSEN, Marten, 22761 Hamburg (DE)
(74) Vertreter: Gagel, Roland
(86) Internationale Anmeldenummer: PCT/DE2007/002226
(87) Internationale Veröffentlichungsnummer: WO 2008/071172

(56) Entgegenhaltungen:
- WO-A-97/02506
- US-A1- 2005 213 230
- US-A1- 2005 231 793
- US-B1- 7 079 299

## Beschreibung

### Technisches Anwendungsgebiet

Die vorliegende Erfindung betrifft einen Mikrospiegel-Aktuator, der in einem inneren Bereich zumindest ein bewegliches Mikrospiegelelement und mehrere finger- oder kammförmige Elektroden zur Ansteuerung des Mikrospiegelelementes aufweist, die in der Höhe gegeneinander versetzt sind, wobei der Aktuator aus einem Schichtaufbau aus zumindest drei Hauptschichten gebildet ist, die über Zwischenschichten zumindest abschnittsweise elektrisch voneinander isoliert sind, sowie ein Verfahren zu dessen Herstellung.

Mikroelektromechanische Bauteile (MEMS) sind für zahlreiche Anwendungen einsetzbar. Beispiele hierfür sind Beschleunigungssensoren, Drehratensensoren oder optische Mikroscanner. Viele dieser MEMS-Bauteile unterscheiden sich in der Art der Ansteuerung oder der Abtastung des Aktor- oder Sensorelementes, das durch eine bewegliche Struktur im inneren Bereich des Bauteils gebildet wird. Die vorliegende Erfindung befasst sich mit Mikrospiegel-Aktuatoren, bei denen das bewegliche Mikrospiegelelement durch mehrere Elektroden angesteuert oder abgetastet wird. Ein besonderes Anwendungsgebiet stellen hierbei elektrostatisch angetriebene Mikroscannerspiegel dar.

### Stand der Technik

Mikroscannerspiegel können beispielsweise in Barcode-Lesegeräten, in Leiterplattenbelichtern, in Laserscanmikroskopen, in der bildgebenden Laserprojektion oder in optischen Netzwerkschaltern zum Einsatz kommen.

Für die Ansteuerung der durch Spiegelplatten gebildeten Aktorelemente von Mikroscannerspiegeln werden zum Teil kammförmige bzw. fingerförmige Elektroden eingesetzt, um große Auslenkungen des Aktorelementes auch bei moderaten Antriebsspannungen zu ermöglichen. Der Vorteil kammförmiger, ineinander greifender Elektroden besteht in einer vergrößerten elektrischen Kapazität durch die größere Elektrodenfläche bei gleichzeitig geringem Elektrodenabstand auch während der Bewegung. Prinzipiell bestehen diese Kammelektrodenantriebe aus einem stationären am Substrat und einem beweglichen am Aktorelement angebrachten Elektrodenkamm, die ineinander greifen. Eine Auslenkung des Aktorelementes wird in einigen Ausgestaltungen bei in der gleichen Ebene liegenden Elektroden dadurch erreicht, dass fertigungsbedingte Asymmetrien der Elektrodenstruktur nicht vollständig identische elektrische Felder an den ineinander greifenden Elektrodenkämmen erzeugen. Bei Anregung des Aktorelementes bei seiner Resonanzfrequenz lassen sich anfänglich sehr kleine Auslenkungen zu großen Amplituden von einigen Grad aufschaukeln. Ein Nachteil dieses Prinzips besteht darin, dass ein derartiger Spiegelaktuator nur bei seiner Resonanzfrequenz nutzbar große Auslenkungen zeigt und daher in seinen Einsatzmöglichkeiten stark eingeschränkt ist. Darüber hinaus ist der Einschwingvorgang durch eine fehlende Vorzugsrichtung nicht eindeutig definiert, so dass das Aktorelement in unterschiedliche Richtungen anschwingen kann. Die Phasenlage des Aktorelementes in Bezug auf sein Anregungssignal ist somit nicht eindeutig definiert und kann um 180° schwanken.

Zur Vermeidung dieser Problematik werden Kammelektroden eingesetzt, bei denen statischer und beweglicher Elektrodenkamm einen gegenseitigen Höhenversatz aufweisen. Mit einer derartigen Anordnung ist es möglich, definiert einen Winkel innerhalb eines Verkippungsbereichs des Aktorelementes einzustellen, der durch den Höhenversatz der Kammelektroden vorgegeben ist. Neben dem resonanten Betrieb ist damit auch ein quasi statischer Betrieb zumindest bei Frequenzen unterhalb der Resonanz möglich.

Aus der Veröffentlichung von E. T. Carlen et al., High-Aspect Ratio Vertical Comb-Drive Actuator With Small Self-Aligned Finger Gaps, Journal of Microelectromechanical Systems, Vol. 14, No. 5, October 2005, Seiten 1144 bis 1155 ist ein Verfahren zur Herstellung eines derartigen Mikroaktuators bekannt, bei dem ein Schichtaufbau aus drei Hauptschichten erzeugt wird, die über Zwischenschichten zumindest abschnittsweise elektrisch voneinander isoliert sind. Diese Schichten werden zur Bildung des Aktorelementes und der gegeneinander in der Höhe versetzten kammförmigen Ansteuerelektroden ausgestaltet und strukturiert.

Zur Herstellung von mikroelektromechanischen Bauteilen, wie den vorangehend beschriebenen Mikroscannerspiegeln, ist ein Schutz der beweglichen Strukturen, d. h. der beweglichen Aktor- oder Sensorelemente, noch während des Herstellungsprozesses erforderlich. Gerade beim Vereinzelungsprozess, bei dem der Wafer mit den nebeneinander prozessierten Bauteilen in einzelne Aktuator-Chips zerteilt wird, treten bei noch nicht gekapselten Bauteilen durch den Sägeprozess Verunreinigungen mit Wasser und Sägestaub auf. Diese können sehr schnell zu elektrischen Kurzschlüssen oder mechanischen Blockaden der mikrometerfeinen Antriebs-Kammstrukturen führen. Da gerade viele Mikroscannerspiegel eine geätzte Rückseiten-Grube aufweisen und die eigentliche Aktorstruktur eine nicht selten nur wenige 10 µm Dicke aber zugleich mehrere Millimeter ausgedehnte Membran darstellt, ist das Bauteil bzw. der Chip im ungekapselten Zustand auch mechanisch sehr fragil. Eine hohe Fertigungsausbeute ist daher nur durch ein sog. Wafer-Level-Packaging möglich, bei dem der innere Bereich des Bauteils, in dem das bewegliche Sensor-oder Aktorelement sowie die Elektroden angeordnet sind, bereits auf dem Wafer vor dem Vereinzeln hermetisch dicht abgeschlossen wird. Damit wird auch erreicht, dass das Bauteil auch unter stark schwankenden Umgebungsbedingungen (Temperatur, Druck, Luftfeuchte) ein gleich bleibendes elektromechanisches Verhalten aufweist.

Viele bisher bekannten Fertigungsprozesse für Mikroscannerspiegel lassen sich jedoch mit einem auf anodischem oder eutektischem Wafer-Bonden basierenden Prozess zur Erzielung einer hermetisch dichten Kapselung nicht oder nur sehr eingeschränkt vereinbaren, da die Problematik der Kontaktierung der Elektroden von außen dies bisher nicht uneingeschränkt zulässt.

So erfordert die Ansteuerung eines einachsigen elektrostatisch angetriebenen Mikroscannerspiegels im einfachsten Fall zwei unterschiedliche Potentiale, die außerhalb der Kapselung über Anschlüsse angelegt und dann in die hermetisch dichte Kapselung geführt werden müssen. Dies ist möglich, wenn der Herstellungsprozess zwei vertikal übereinander liegende und zueinander isolierte leitfähige Aktuatorschichten vorsieht. Der so hergestellte einachsige Spiegel könnte bei Anlegen einer Gleichspannung einseitig quasistatisch ausgelenkt werden oder mittels einer geeigneten alternierenden Spannung in Resonanz gebracht werden. Wird jedoch mehr als ein Kammelektroden-Paar für die Ansteuerung eingesetzt, etwa um den einachsigen Spiegel nicht nur einseitig sondern zu beiden Seiten quasistatisch auslenken zu können, dann werden bereits drei voneinander isolierte Potentiale benötigt, von denen mindestens zwei auch lateral voneinander isoliert und räumlich getrennt sein müssen. Die bisher bekannten Herstellungsverfahren unterteilen dazu die oberste Potential führende Schicht in räumlich und elektrisch voneinander getrennte Gebiete, in der Regel durch Ätzen eines Grabens hinunter bis zur nächsten Isolatorschicht. Diese zur elektrischen Trennung erforderlichen Gräben stehen jedoch dem hermetischen Wafer-Level-Packaging im Wege, da die Gräben stets einen Gasaustausch zwischen dem gekapselten Innen- und dem Außenraum zulassen. Im Falle eines anodischen

Bondverfahrens zur Kapselung wird die Bondung an der Grabenstelle unterbrochen. Im Falle des eutektischen Bondens wird sogar ein Kurzschluss der zueinander zu isolierenden Leiterbahnen erzeugt. Die Verhältnisse werden noch deutlich komplexer, wenn nicht ein einachsiger sondern ein zweiachsiger MikroscannerSpiegel hergestellt werden soll, da bei letzterem noch weitere räumlich zu trennende Potentiale hinzukommen.

Aus der US 6,146,917 ist ein Wafer-Level-Packaging-Verfahren für MEMS-Bauteile bekannt, bei dem ein mit Kavitäten versehener Silizium- oder Glaswafer entweder durch Fusionbonding oder durch anodisches Bonden mit dem MEMS-Wafer verbunden wird, um eine hermetische Kapselung zu erreichen. Bei dem Herstellungsprozess wird auf der durch den Wafer gebildeten untersten Schicht ein das Bauteil umgebender geschlossener Bondbereich mit einer für die hermetisch dichte Verbindung mit einem Deckelelement erforderlichen Planarität freigehalten. Das Deckelelement ist ein mit Kavitäten versehener Silizium- oder Glaswafer, der an den Stellen dieses umlaufenden Bondbereichs geeignete Stege aufweist. Die elektrische Verbindung der Elektroden des verkapselten MEMS-Bauteils nach außen erfolgt durch in den Wafer implantierte Leiterbahnen, die lateral von außen in den gekapselten inneren Bereich des MEMS-Bauteils führen.

Die Aufgabe der vorliegenden Erfindung besteht darin, ein Verfahren zur Herstellung eines Mikrospiegel-Aktuators mit zumindest einem beweglichen Mikrospiegelelement und mehreren in der Höhe gegeneinander versetzten finger- oder kammförmigen Elektroden anzugeben, das eine hermetisch dichte Verkapselung des inneren Bereiches des Aktuators bereits auf Wafer-Ebene auf einfache Weise ermöglicht. Weiterhin soll mit der Erfindung ein entsprechend aufgebauter Mikrospiegel-Aktuator bereitgestellt werden.

### Darstellung der Erfindung

Die Aufgabe wird mit dem Verfahren und dem Mikrospiegel-Aktuator gemäß den Patentansprüchen 1 und 8 gelöst. Vorteilhafte Ausgestaltungen des Verfahrens sowie des Aktuators sind Gegenstand der Unteransprüche oder lassen sich der nachfolgenden Beschreibung sowie den Ausführungsbeispielen entnehmen.

Bei dem vorliegenden Verfahren wird ein Schichtaufbau aus zumindest drei Hauptschichten erzeugt, vorzugsweise Halbleiterschichten, die über Zwischenschichten zumindest abschnittsweise elektrisch voneinander isoliert sind. Die Schichten werden zur Bildung des Mikrospiegelelementes und der Elektroden ausgestaltet und strukturiert. Bei dem vorgeschlagenen Verfahren erfolgt die Strukturierung der Schichten derart, dass zumindest aus der oberen Hauptschicht ein geschlossener (massiver) Rahmen erhalten wird, der den inneren Bereich des Aktuators umgibt und eine hermetische Kapselung des inneren Bereichs durch Aufbringen einer Deckplatte auf den Rahmen ermöglicht. Vorzugsweise wird die Oberfläche der Oberseite des Rahmens, d. h. die Oberfläche der obersten Schicht des Rahmens, hierzu nach der Strukturierung geeignet poliert, falls die für ein hermetisch dichtes Aufbringen einer Deckplatte erforderliche Planarität noch nicht ausreicht. Weiterhin wird bei dem vorliegenden Verfahren bei der Erzeugung des Schichtaufbaus zwischen zumindest zwei der Schichten eine von diesen Schichten über die Zwischenschichten elektrisch isolierte Leiterbahnebene erzeugt und zur Bildung von Leiterbahnen strukturiert. Die Strukturierung erfolgt dabei derart, dass über die Leiterbahnen nach der Bildung von Kontaktöffnungen in ein oder mehreren der Zwischenschichten bei der Herstellung des Bauteils ein oder mehrere der Elektroden von außerhalb des Rahmens elektrisch kontaktierbar sind. Vorzugsweise werden die Elektroden hierbei durch zumindest zwei der Hauptschichten gebildet, zwischen denen dann auch die Leiterbahnebene erzeugt wird. Durch diese vergrabenen Leiterbahnen wird somit eine Kontaktierung der Elektroden von außerhalb des Rahmens bzw. der Kapselung erreicht, ohne die für die Kapselung erforderliche planare Oberflächenqualität der Verbindungsflächen für die Kapselung zu zerstören. Das Verfahren ermöglicht damit in einfacher Weise die Herstellung einer hermetisch dichten Kapselung, vorzugsweise mittels anodischem oder eutektischem Waferbonden für die Verbindung der Deckplatte mit dem Rahmen. Anstelle dieser beiden Bondverfahren lassen sich auch andere Verbindungstechniken, beispielsweise Glasfrit-Bonden, für die Herstellung der Verbindung nutzen.

Diese Kapselung kann bei dem vorgeschlagenen Verfahren bereits auf Wafer-Ebene erfolgen, wobei dann ein weiterer Wafer oder ein Substrat von der Größe eines Wafers als Deckplatte auf den Schichtaufbau aufgebracht und mit den Rahmen der auf dem Wafer nebeneinander angeordneten Mikrospiegel-Aktuatoren hermetisch dicht verbunden wird. Die Deckplatte kann hierbei in bekannter Weise auch Kavitäten aufweisen, um die Bewegungsfreiheit der Mikrospiegelelemente durch die Deckplatte nicht zu beeinträchtigen. Weist der Aktuator, im Folgenden auch als Bauteil bezeichnet, eine durch die unterste Hauptschicht durchgehende Öffnung auf, so muss für die hermetisch dichte Kapselung auch ein zusätzlicher Bodendeckel vorgesehen werden. Dies ist unproblematisch, da die unterste Hauptschicht in der Regel aus einem Wafer besteht, dessen Unterseite eine ausreichende Planarität für die Verbindung mit einem weiteren Substrat oder Wafer als Bodenplatte aufweist.

Bei der Herstellung eines Mikroscannerspiegels oder eines anderen MEMS-Bauteils für optische Anwendungen ist es erforderlich, die Deckplatte, möglicherweise auch eine evtl. erforderliche Bodenplatte, aus einem in zumindest einem optischen Wellenlängenbereich transparenten Material, bspw. aus Glas, zu wählen. Dies stellt bei dem vorliegenden Verfahren jedoch kein Problem dar.

Der hier vorgeschlagene Fertigungsprozess sieht stets einen vollständig in sich geschlossenen polierten oder topographiefreien Rahmen um den inneren Bereich mit dem Mikrospiegelelement und den Elektroden vor, dessen oberster Teil aus der gleichen Schicht gefertigt wird, aus der auch die oberste Aktuator(haupt)schicht hergestellt ist. Um dennoch eine nahezu beliebige Anzahl voneinander getrennter Potentiale in die Kapselung hineinführen zu können, umfasst der vorgeschlagene Herstellungsprozess neben zwei dicken, elektrisch leitfähigen Aktuatorschichten, die bspw. für Spiegelplatte bzw. Mikrospiegelelement, Feder-Aufhängungen und die höhenversetzten Elektroden-Kammstrukturen eingesetzt werden können, auch eine abgeschiedene Leiterbahnebene. Diese Leiterbahnebene befindet sich vorzugsweise über der unteren Aktuatorschicht, aber elektrisch isoliert zu dieser, und unter der oberen Aktuatorschicht, ebenfalls elektrisch isoliert zu dieser. Über diese Leiterbahnebene können nun gegeneinander durch Gräben isolierte Inseln der oberen Aktuatorschicht, die sich innerhalb des inneren Bereiches befinden, kontaktiert werden. Hierzu werden vorher Kontaktlöcher in der sich unter der oberen Aktuatorschicht befindenden Isolationsschicht zu der in geeignete einzelne Leiterbahnen strukturierten Leiterbahnebene erzeugt, über die die elektrische Verbindung zwischen den Leiterbahnen und den isolierten Inseln der oberen Aktuatorschicht erfolgt.

Der vorgeschlagene Herstellungsprozess erlaubt die Erzeugung von zueinander höhenversetzten Kammelektroden. Diese höhenversetzten Kammelektroden ermöglichen nicht nur resonanten sondern auch quasistatischen Betrieb des elektrostatisch angetriebenen Mikrospiegelelementes. Der beschriebene Herstellungsablauf bietet die Möglichkeit, bewegliche Aktuatorstrukturen in mindestens drei verschiedenen Schichtdicken zu erzeugen. So kann eine Torsionsfeder für die Aufhängung des Mikrospiegelelementes bei Bedarf in der geringsten Schichtdicke hergestellt werden, während Elektrodenkämme für den Antrieb bzw. die Ansteuerung bspw. in der mittleren Schichtdicke erzeugt werden und das Mikrospiegelelement je nach Bedarf in einer der drei zur Verfügung stehenden Schichtdicken gefertigt wird. Während im Falle eines Mikroscannerspiegels sehr kleine Spiegeldurchmesser (< 0,5 mm) schon mit einer geringen Schichtdicke auskommen können, weil die statische Deformation mit dem Quadrat der Kantenlänge und die dynamische Deformation mit der fünften Potenz der Kantenlänge des Spiegels skalieren, benötigen mittlere und große Spiegeldurchmesser (bis zu mehreren Millimeter) entsprechend größere Schichtdicken. Neben nur wenigen 10 µm dicken Spiegeln erlaubt der hier vorgestellte Herstellungsprozess auch die Fertigung eines bis zu vielen hundert µm dicken Spiegels, bspw. in der Dicke eines Wafers. Allein das Design der Photomasken für die Strukturierung bestimmt die Dicke der jeweiligen Aktuatorstruktur. Der Fertigungsablauf bleibt stets der gleiche.

Bei dem in der vorliegenden Patentanmeldung beschriebenen Herstellungsablauf werden vorzugsweise nur Hochtemperatur-feste Materialien eingesetzt, wodurch Hochtemperatur-Wafer-Bond-Verfahren wie bspw. anodisches oder eutektisches Bonden, genutzt werden können, ohne dem Aktuator zu schaden. Anders als bei Herstellungsprozessen, bei denen Leiterbahnen aus der gleichen Schicht hergestellt werden wie die Antriebselektroden, können mit der hier vorgesehen verborgenen bzw. vergrabenen Leiterbahnebene beliebig viele gegeneinander isolierte Bereiche des Aktuators auch dann kontaktiert werden, wenn der Aktuator durch ein Wafer-Level-Package hermetisch dicht verpackt ist.

Der mit dem Verfahren hergestellte Mikrospiegel-Aktuator weist in einem inneren Bereich zumindest ein bewegliches Mikrospiegelelement und mehrere in der Höhe versetzte kamm- oder fingerförmige Elektroden zur Ansteuerung des Mikrospiegelelementes auf. Das Bauteil ist aus einem Schichtaufbau aus zumindest drei Hauptschichten gebildet, die über Zwischenschichten zumindest abschnittsweise elektrisch voneinander isoliert sind. Der innere Bereich wird von einem zumindest aus der oberen Hauptschicht gebildeten geschlossenen Rahmen umgeben, der eine hermetische Kapselung des inneren Bereichs durch Aufbringen einer Deckplatte auf den Rahmen ermöglicht. Zwischen zumindest zwei der Schichten ist eine von diesen Schichten über die Zwischenschichten elektrisch isolierte Leiterbahnebene mit Leiterbahnen angeordnet, über die über Kontaktöffnungen in den Zwischenschichten ein oder mehrere der Elektroden von außerhalb des Rahmens elektrisch kontaktierbar sind. Vorzugsweise handelt es sich bei dem Mikrospiegel-Aktuator um einen Mikroscannerspiegel mit einem elektrostatisch angetriebenen ein- oder mehrachsigen Mikrospiegel.

### Kurze Beschreibung der Zeichnungen

Das vorgeschlagene Verfahren sowie der zugehörige Mikrospiegel-Aktuator werden nachfolgend anhand von Ausführungsbeispielen in Verbindung mit den Zeichnungen nochmals näher erläutert. Hierbei zeigen:
- Fig. 1: ein erstes Beispiel für das vorge-schlagene Herstellungsverfahren;
- Fig. 2: ein zweites Beispiel für das vorgeschlagene Herstellungsverfahren;
- Fig. 3: eine Draufsicht auf einen zweiachsigen Mikroscannerspiegel wie er gemäß dem vorliegenden Verfahren erhalten werden kann;
- Fig. 4: ein Beispiel für den Höhenversatz und die Ansteuerung der Kammelektroden;
- Fig. 5: ein zweites Beispiel für den Höhenversatz und die Anordnung der Kammelektroden;
- Fig. 6: ein drittes Beispiel für den Höhenversatz und die Anordnung der Kammelektroden; und
- Fig. 7: ein Beispiel für die Kapselung des vorgeschlagenen Mikrospiegel-Aktuators.

### Wege zur Ausführung der Erfindung

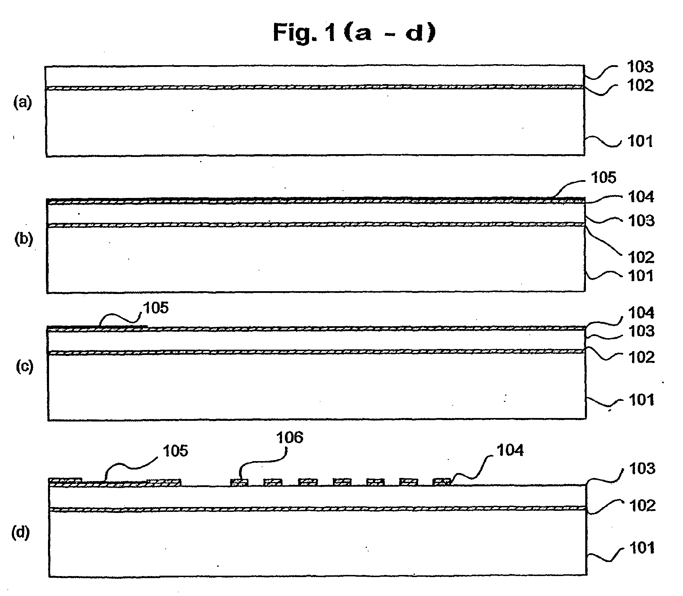

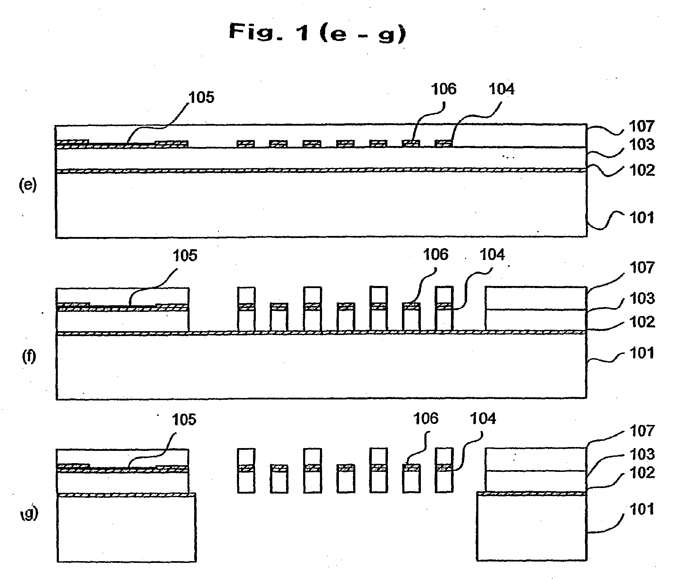

Im Folgenden wird das vorgeschlagene Verfahren anhand eines Ausführungsbeispiels beschrieben, bei dem ein Mikroscannerspiegel in Siliziumtechnologie hergestellt wird. Die einzelnen Verfahrensschritte können anhand der Teilabbildungen (a) bis (g) der Figur 1 nachvollzogen werden. Als Substrat-Material dient ein Siliziumwafer 101, der durch einen thermischen Oxidationsprozess mit einer SiO₂-Schicht 102 von bspw. 1 µm Dicke belegt wird. Auf diese als erste Isolationsschicht dienende (Zwischen-)Schicht wird eine relativ dicke Polysiliziumschicht 103 von bspw. 30 µm Dicke durch einen Epitaxie-Abscheideprozess aufgebracht. Im Folgenden werden derartige, durch einen Epitaxie-Abscheideprozess aufgebrachte Polysiliziumschichten auch als Epipoly-Schichten bezeichnet.

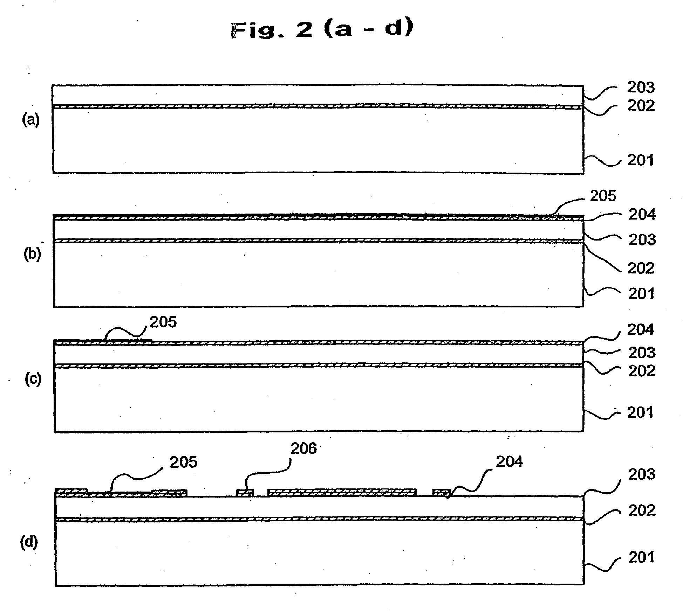

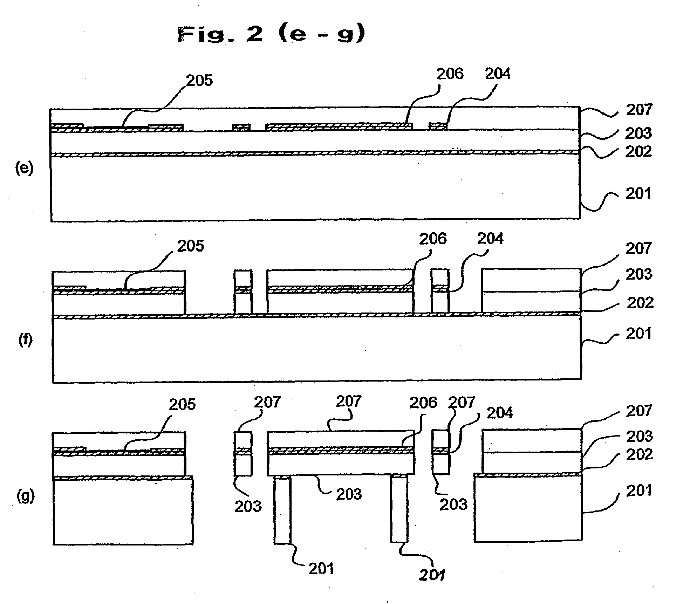

Anschließend wird der Wafer durch chemischmechanisches Polieren (CMP) geglättet. Hierbei wird darauf hingewiesen, dass die Figur 1, ebenso wie die Figur 2, lediglich einen kleinen Teilabschnitt des Wafers zeigt, auf dem ein Mikroscannerspiegel erzeugt wird. Auf dem gesamten Wafer werden durch den Schichtaufbau in bekannter Weise sehr viele derartige Mikroscannerspiegel gleichzeitig nebeneinander aufgebaut.

Alternativ zu diesen ersten Schritten kann auch ein kommerzielles, einkristallines SOI-Wafersubstrat eingesetzt werden.

Auf die Epipoly-Schicht 103 werden nun ein CVD-Oxid (TEOS) 104 und eine weitere Polysiliziumschicht 105 abgeschieden, wobei die Polysiliziumschicht 105 durch einen Trockenätzprozess strukturiert wird (Fig. 1, Teilabbildungen (b) und (c)). Darauf wird eine weitere TEOS-Oxidschicht 106 abgeschieden, die anschließend zusammen mit der bereits vorhandenen durch einen kombinierten Nass-Trocken-Ätzschritt strukturiert wird (Fig. 1, Teilabbildung (d)). Auf diese Schichtfolge wird eine weitere Epipoly-Schicht 107 abgeschieden, die wiederum durch CMP geglättet wird (Fig. 1, Teilabbildung (e)). Nun kann diese oberste Schicht optional mit einem geeigneten Metall oder einer dielektrischen Verspiegelungsschicht belegt werden, um bspw. die Reflektivität der späteren Spiegelplatte zu erhöhen.

In einem einzigen Hochratenätzschritt, bei dem die vergrabenen TEOS-Oxidschichten als vergrabene Hartmaskierung fungieren, werden beide Epipoly-Schichten (103, 107) strukturiert (Fig. 1, Teilabbildung (f)). Um die Aktuatorstruktur freizustellen, muss das Substrat von der Rückseite her geätzt werden. Ein letzter Ätzschritt entfernt die erste Oxidschicht 102, die das Substrat 101 von den darüber liegenden Schichten trennt (Fig. 1, Teilabbildung (g)).

Bei diesem beispielhaften Verfahrensablauf wird der Mikroscannerspiegel somit aus drei Hauptschichten aufgebaut, die dem Substrat 101 und den beiden Epipoly-Schichten 103, 107 entsprechen. Diese dicken Hauptschichten werden durch entsprechende Zwischenschichten, der SiO₂-Schicht 102 und den TEOS-Oxidschichten 104, 106 elektrisch voneinander isoliert. Zwischen den beiden TEOS-Oxidschichten 104, 106 bildet die Poly-siliziumschicht 105 eine Leiterbahnebene, die beim Herstellungsprozess zur Erzeugung der gewünschten Leiterbahnen strukturiert wird.- Über diese Leiterbahnen können durch Einbringen von Kontaktlöchern in die obere TEOS-Oxidschicht 106, entsprechende Bereiche der oberen Hauptschicht (Epipoly-Schicht 107), elektrisch kontaktiert werden. Die Leiterbahnen sind von der Seite des Schichtaufbaus her zugänglich, wie dies bspw. in Teilabbildung (g) ersichtlich ist.

Die Strukturierung der Haupt- und Zwischenschichten erfolgt bei dem vorgeschlagenen Verfahren nicht nur derart, dass die gewünschte Aktuatorstruktur mit entsprechenden (in der Figur nicht ersichtlichen Aufhängungen) und den zugehörigen Elektroden resultiert, sondern auch zur Bereitstellung eines geschlossenen Rahmens um den inneren Bereich des Bauteils, in dem die Elektroden und das Aktorelement angeordnet sind. Dieser Rahmen ist in Teilabbildung (g) der Figur 1 auf beiden Seiten der in dieser Abbildung erkennbaren freiliegenden Elektroden ersichtlich. Die Oberfläche der obersten Schicht, der Epipoly-Siliziumschicht 107, dieses Rahmens wird zusätzlich geeignet poliert, bspw. mittels CMP, um eine für ein anschließendes eutektisches oder anodisches Bonden mit einer Deckplatte ausreichend planare Oberflächenqualität von vorzugsweise ≤ 2 nm RMS zu erhalten.

In dem in Figur 1 gezeigten Beispiel gehen die Elektroden, die aus der unteren Epipoly-Schicht 103 gebildet sind, in die Spiegelplatte (aus der gleichen Schicht) über, die in der Figur nicht erkennbar ist. Die restlichen Elektroden aus der Kombination der Epipoly-Schichten 103 und 107 sind starr am Substrat 101 verankert. Der grundsätzliche Aufbau eines derartigen Mikroscannerspiegels mit den in dieser Figur nicht dargestellten Aufhängungen ist dem Fachmann bekannt. Hierzu kann bspw. auf die in der Beschreibungseinleitung genannten Druckschriften verwiesen werden.

Für die hermetisch dichte Kapselung des inneren Bereiches eines derartig aufgebauten Mikroscannerspiegels ist im vorliegenden Fall auch die Anbringung einer Bodenplatte erforderlich, die von der Rückseite, d. h. in der Figur 1 von unten, an das Substrat 101 gebondet wird. Hierbei kann es sich bspw. um einen weiteren Wafer handeln. Die Deckplatte, die auf den Rahmen dieses Bauteils bzw. des Schichtaufbaus mit einer Vielzahl derartiger Bauteile auf dem Wafer gesetzt wird, muss in diesem Beispiel im Bereich des inneren Bereiches der Bauteile eine Kavität aufweisen, um die Bewegung des Mikrospiegels nicht zu behindern. Derartige Deckplatten mit Kavitäten sind ebenfalls aus einer der beiden in der Beschreibungseinleitung genannten Druckschriften bereits bekannt, so das an dieser Stelle nicht weiter darauf eingegangen wird.

Figur 2 zeigt den gleichen Herstellungsablauf wie bei Figur 1, so dass auf die einzelnen Teilschritte hier nicht mehr näher eingegangen wird. Die Teilabbildungen (a) bis (g) der Figur 2 korrespondieren hierbei mit den Teilabbildungen (a) bis (g) der Figur 1. Im Unterschied zu der Ausgestaltung der Figur 1 wird bei dem Beispiel der Figur 2 ein Teil der gefertigten Aktuator-Struktur in der maximalen Schichtdicke hergestellt und besteht somit aus dem Substrat 201 als erster Hauptschicht, der Epipoly-Schicht 203 als zweiter Hauptschicht und der Epipoly-Schicht 207 als dritter Hauptschicht. Der Vorteil einer derart dicken Aktuatorstruktur besteht in der erzielbaren Biege- und Torsionssteifigkeit der Aktuatorstruktur. Als beispielhafte Anwendung kann hier ein mehrere Millimeter langer Mikrospiegel angeführt werden, dessen statische und dynamische Deformationen minimiert werden müssen.

Zusätzlich kann durch Schichtabscheidung und Strukturierung die oberste Hauptschicht 207 im Bereich der Spiegelplatte mit einer Reflexionsschicht versehen werden, beispielsweise in Form einer Metallschicht oder einer dielektrischen Verspiegelungsschicht, wodurch sich die Oberflächenqualität der Hauptschicht 207 im Bereich des Bondrahmens nicht verringert.

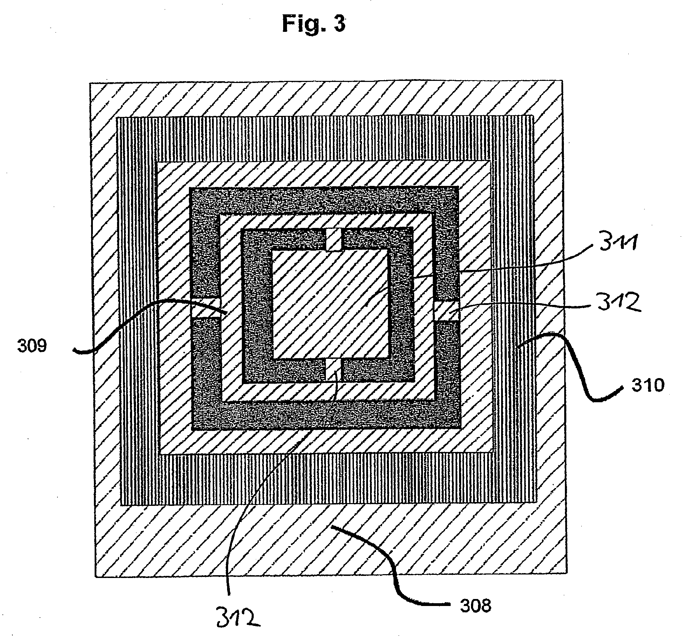

Figur 3 zeigt ein Beispiel eines zweiachsigen Mikroscannerspiegels 309 in Draufsicht. In der Figur sind der die Spiegelplatte 311 mit den Aufhängungen 312 sowie die umgebenden Gebiete dargestellt. Der innere Bereich dieses Bauteils mit den in dieser Figur nicht dargestellten Kammelektroden wird von dem topographiefreien Rahmen 310 umgeben, der an der Oberfläche poliert ist. Dieser Rahmen 310 bildet aufgrund seiner Topographiefreiheit eine Bondfläche für ein hermetisches Wafer-Level-Package. Der Bereich 308 stellt ein Gebiet außerhalb der Aktuatorkapsel dar.

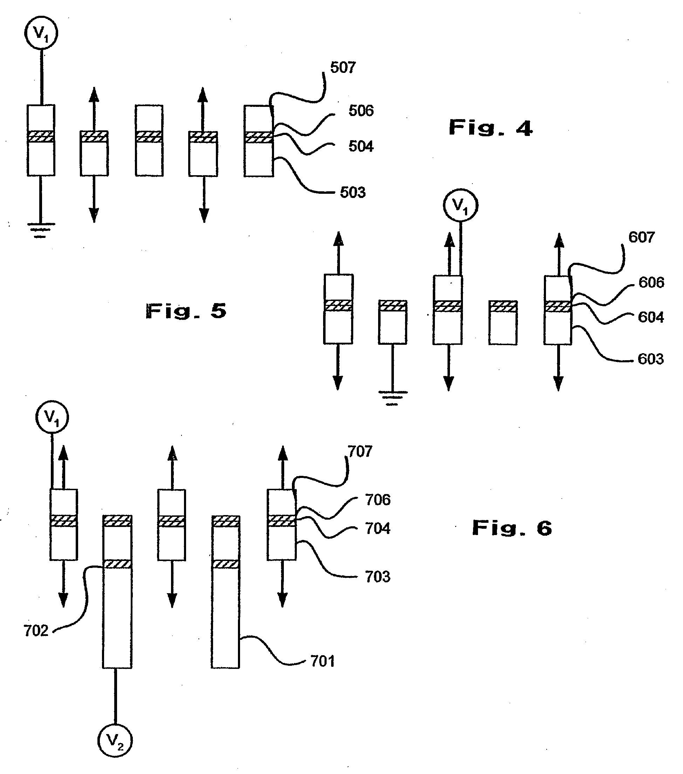

In den folgenden Figuren 4 bis 6 werden unterschiedliche Ausgestaltungen und Ansteuerungen der kammförmigen Elektroden kurz erläutert. Um einen Höhenversatz der Elektrodenkämme zu erzielen, kann die bewegliche Struktur, das Aktorelement, mit Elektrodenkämmen ausgestattet werden, die alleine durch die untere Epipoly-Schicht 503 gebildet werden, während die statischen Gegen-Kammelektroden aus beiden gegeneinander isolierten Epipoly-Schichten 503 und 507 hergestellt werden. Die elektrische Ansteuerung ist in dieser wie auch den beiden folgenden Figuren angedeutet.

Alternativ dazu kann, wie in Figur 5 gezeigt, auch die bewegliche Struktur mit Kammelektroden hergestellt werden, welche aus beiden Epipoly-Schichten 603, 607 aufgebaut sind, während die dazu statische Gegen-Kammelektrode nur durch die untere Epipoly-Schicht 603 gebildet ist.

Bei einer weiteren Al.ernative wird eine der Kammstrukturen, vorzugsweise die statische Kamm-struktur, aus mindestens den unteren Schichten, d.h. dem Substrat 701 und der Epipoly-Schicht 703, hergestellt, während die bewegliche Gegen-Kammstruktur vorzugsweise aus den Epipoly-Schichten 703 und 707 aufgebaut wird. Setzt man die aus Epipoly-Schicht 707 gefertigten Kammstrukturanteile auf Potential V1, die aus Epipoly-Schicht 703 gefertigten Anteile durchgängig auf ein davon verschiedenes Potential, bspw. Masse, und die aus dem Substrat 701 gefertigten Anteile auf Potential V2, dann ergibt sich eine Anordnung zweier übereinander gestapelter höhenversetzter Kammantriebe, die mehr Kraft ausüben können als ein einfacher höhenversetzter Kammantrieb. Ein weiterer Vorteil eines derartigen Aufbaus besteht darin, dass die beweglich aufgehängte Kammstruktur einen mindesten doppelt so großen vertikalen Hub durchführen kann, da sich die Kapazität der gegenüberliegenden Elektroden bei einer vertikalen Relativbewegung über eine mindestens doppelt so große Distanz hinweg ändert. Hierbei wird vorausgesetzt, dass die Epipoly-Schichten 703 und 707 die gleiche Dicke aufweisen.

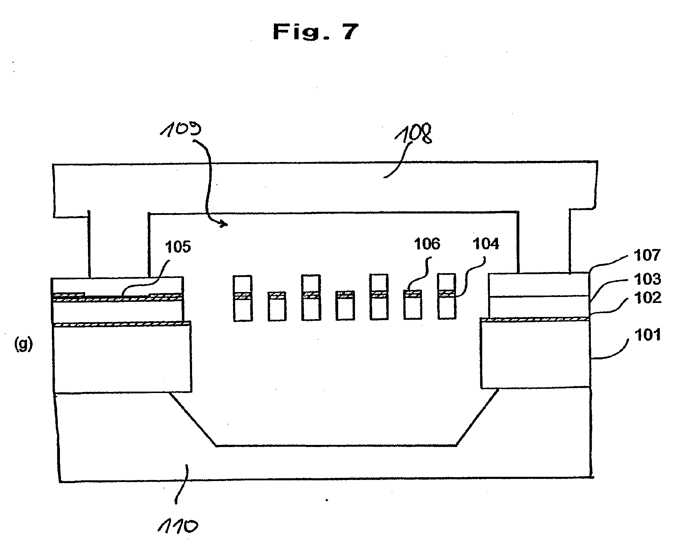

Figur 7 zeigt schließlich noch ein Beispiel für einen Zustand, bei dem der hergestellte Mikroscannerspiegel auf Waferebene durch Aufbringen einer Deckplatte und einer Bodenplatte hermetisch dicht verkapselt ist. Das gesamte aus drei Wafern bestehende Wafer-Level-Package ist hierbei im Querschnitt dargestellt. Auf die Oberseite des MEMS-Wafers, dem Substrat 101, mit den darauf angeordneten Schichten, ist ein vorprozessierter Glas-Deckelwafer 108 anodisch aufgebondet. Dies wird durch den ohne Unterbrechung umlaufenden Rahmen um den inneren Bereich ermöglicht, dessen Oberseite durch die Epipoly-Schicht 107 gebildet wird, deren Oberfläche zusätzlich poliert ist. Dieser Glas-Deckelwafer 108 weist geeignete Kavitäten 109 auf, die die bestimmungsgemäße Bewegung des Aktorelementes innerhalb des verkapselten Bereiches ermöglichen. Der MEMS-Wafer wird ebenfalls rückseitig durch einen anodisch oder eutektisch aufgebondeten Glas-Bodenwafer 110 verschlossen. Dies stellt aufgrund der hohen Oberflächenqualität der Rückseite des Wafersubstrates 101 kein Problem dar.

Das vorgeschlagene Verfahren eignet sich, wie in den Ausführungsbeispielen dargestellt, bspw. für die Herstellung von elektrostatisch angetriebenen ein- und mehrachsigen Mikroscannerspiegeln. Das Verfahren ermöglicht die Herstellung von finger- bzw. kammförmigen Antriebselektroden, die über einen vertikalen Höhenversatz verfügen und über zueinander getrennte Potentiale angesteuert werden können. Eine zusätzliche Verdrahtungsebene zwischen diesen beiden Ebenen ermöglicht es, beliebig viele gegeneinander isolierte Ansteuer- oder Sensorik-Potentiale zu realisieren. Ein geschlossener Rahmen, der den inneren Bereich des Bauteils umgibt und zumindest durch die oberste Halbleiterschicht gebildet ist, ermöglicht dabei ein hermetisch dichtes Wafer-Level-Package, bspw. durch anodisches oder eutektisches Wafer-Bonden. Die integrierte vergrabene Leiterbahnebene verbindet dabei externe Anschlussareale durch laterale Durchführungen mit den Elektroden des Aktuators, ohne die für die hermetisch dichte Verkapselung erforderliche Oberflächenqualität des Rahmens zu beeinträchtigen. Durch den Verfahrensablauf lassen sich Spiegelplatte, Aufhängungsstrukturen und Elektroden unabhängig voneinander in zumindest in drei unterschiedlichen Schichtdicken realisieren. Dem Problem einer dynamischen Spiegeldeformation kann durch diese drei lokal wählbaren Schichten mit den damit möglichen unterschiedlichen Biege-Versteifungen vorteilhaft entgegengewirkt werden.

### Bezugszeichenliste

- 101: Siliziumwafer
- 102: SiO2-Schicht
- 103: Epipoly-Schicht
- 104: TEOS-Oxidschicht
- 105: Polysilizium-Schicht
- 106: TEOS-Oxidschicht
- 107: Epipoly-Schicht
- 108: Glas-Deckelwafer
- 109: Kavitäten
- 110: Glas-Bodenwafer
- 201: Siliziumwafer
- 202: SiO2-Schicht
- 203: Epipoly-Schicht
- 204: TEOS-Oxidschicht
- 205: Polysilizium-Schicht
- 206: TEOS-Oxidschicht
- 207: Epipoly-Schicht
- 309: Mikroscannerspiegel
- 310: Rahmen
- 311: Spiegelplatte
- 312: Aufhängungen
- 503: Epipoly-Schicht
- 504: TEOS-Oxidschicht
- 506: TEOS-Oxidschicht
- 507: Epipoly-Schicht
- 603: Epipoly-Schicht
- 604: TEOS-Oxidschicht
- 606: TEOS-Oxidschicht
- 607: Epipoly-Schicht
- 701: Siliziumwafer
- 702: SiO2-Schicht
- 703: Epipoly-Schicht
- 704: TEOS-Oxidschicht
- 706: TEOS-Oxidschicht
- 707: Epipoly-Schicht

## Patentansprüche

1. Verfahren zur Herstellung eines Mikrospiegel-Aktuators, der in einem inneren Bereich zumindest ein bewegliches Mikrospiegelelement und mehrere finger- oder kammförmige Elektroden zur Ansteuerung des Mikrospiegelelementes aufweist, die in der Höhe gegeneinander versetzt sind,
bei dem ein Schichtaufbau aus zumindest drei Hauptschichten (101, 103, 107) erzeugt wird, die über Zwischenschichten (102, 104, 106) zumindest abschnittsweise elektrisch voneinander isoliert sind, und die Schichten zur Bildung des Mikrospiegelelementes und der Elektroden ausgestaltet und strukturiert werden,
wobei die Strukturierung der Schichten derart erfolgt, dass ein geschlossener Rahmen (310) aus zumindest der obersten Hauptschicht (107) erhalten wird, der den inneren Bereich des Aktuators umgibt und eine hermetische Kapselung des inneren Bereichs durch Aufbringen einer Deckplatte auf den Rahmen (310) ermöglicht, und wobei bei der Erzeugung des Schichtaufbaus zwischen zumindest zwei der Hauptschichten eine von diesen Hauptschichten über die Zwischenschichten elektrisch isolierte Leiterbahnebene (105) erzeugt und zur Bildung von Leiterbahnen strukturiert wird, Kontaktöffnungen gebildet werden und über die Leiterbahnen nach der Bildung der Kontaktöffnungen in ein oder mehreren der Zwischenschichten (102, 104, 106) ein oder mehrere der Elektroden von außerhalb des Rahmens (310) elektrisch kontaktierbar sind.

2. Verfahren nach Anspruch 1,
bei dem eine Oberseite des Rahmens (310) nach der Strukturierung poliert wird.

3. Verfahren nach Anspruch 1 oder 2,
bei dem die Herstellung auf Wafer-Ebene durch Erzeugung des Schichtaufbaus für eine Vielzahl von nebeneinander angeordneten Mikrospiegel-Aktuatoren auf einem Wafer erfolgt, der eine der Hauptschichten bildet.

4. Verfahren nach Anspruch 3,
bei dem nach der Strukturierung ein weiterer Wafer (108) oder ein Substrat von der Größe eines Wafers als Deckplatte auf den Schichtaufbau aufgebracht und mit den Rahmen (310) der nebeneinander angeordneten Mikrospiegel-Aktuatoren hermetisch dicht verbunden wird.

5. Verfahren nach Anspruch 4,
bei dem eine Deckplatte eingesetzt wird, die in zumindest einem optischen Wellenlängenbereich transparent ist.

6. Verfahren nach Anspruch 4 oder 5,
bei dem die Deckplatte durch anodisches oder eutektisches Bonden oder durch Glasfritt-Bonden aufgebracht wird.

7. Verfahren nach einem der Ansprüche 1 bis 6,
bei dem die Schichten zur Bildung einer ein- oder mehrachsig beweglichen Mikrospiegelplatte (311) als Mikrospiegelelement ausgestaltet und strukturiert werden.

8. Mikrospiegel-Aktuator, der in einem inneren Bereich zumindest ein bewegliches Mikrospiegelelement und mehrere finger- oder kammförmige Elektroden zur Ansteuerung des Mikrospiegelelementes aufweist, die in der Höhe gegeneinander versetzt sind, wobei
- der Aktuator aus einem Schichtaufbau aus zumindest drei Hauptschichten (101, 103, 107) gebildet ist, die über Zwischenschichten (102, 104, 106) zumindest abschnittsweise elektrisch voneinander isoliert sind,
- der innere Bereich von einem geschlossenen Rahmen (310) aus zumindest der obersten Hauptschicht (107) umgeben ist, der eine hermetische Kapselung des inneren Bereichs durch Aufbringen einer Deckplatte auf den Rahmen (310) ermöglicht, und
- zwischen zumindest zwei der Hauptschichten eine von diesen Hauptschichten über die Zwischenschichten elektrisch isolierte Leiterbahnebene (105) mit Leiterbahnen angeordnet ist, über die über Kontaktöffnungen in ein oder mehreren der Zwischenschichten (102, 104, 106) ein oder mehrere der Elektroden von außerhalb des Rahmens (310) elektrisch kontaktierbar sind.

9. Mikrospiegel-Aktuator nach Anspruch 8,
bei dem das Mikrospiegelelement eine ein- oder mehrachsig bewegliche Mikrospiegelplatte (311) ist.

10. Mikrospiegel-Aktuator nach Anspruch 8 oder 9, bei dem auf den Rahmen (310) eine Deckplatte hermetisch dicht aufgebracht ist.

11. Mikrospiegel-Aktuator nach Anspruch 10, bei dem die Deckplatte in zumindest einem optischen Wellenlängenbereich transparent ist.

## Claims

1. A method for producing a micro-mirror actuator, which has, in an inner area, at least one movable micro-mirror element and multiple finger-shaped or comb-shaped electrodes for activating the micro-mirror element, which are offset to one another in height,
wherein a layered construction made of at least three main layers (101, 103, 107) is generated, which are at least sectionally electrically insulated from one another via intermediate layers (102, 104, 106), and the layers are designed and structured to form the micro-mirror element and the electrodes,
the structuring of the layers being performed in such a way that a closed frame (310) is obtained from at least the uppermost layer (107), which encloses the inner area of the actuator and allows a hermetic encapsulation of the inner area by application of a cover plate on the frame (310), and, during the generation of the layered construction, a conductor level (105), which is electrically insulated from these main layers via the intermediate layers, is generated between at least two of the main layers and structured to form conductor paths, contact openings are formed and one or more of the electrodes may be electrically contacted from outside the frame (310) via the conductor paths after the formation of the contact openings in one or more of the intermediate layers (102, 104, 106).

2. The method according to Claim 1,
wherein a top side of the frame (310) is polished after the structuring.

3. The method according to Claim 1 or 2,
wherein the production is performed on the wafer level by generating the layered construction for a plurality of micro-mirror actuators situated adjacent to one another on a wafer, which forms one of the main layers.

4. The method according to Claim 3,
wherein, after the structuring, a further wafer (108) or a substrate of the size of a wafer is applied as a cover plate to the layered construction and bonded hermetically sealed to the frame (310) of the micro-mirror actuators situated adjacent to one another.

5. The method according to Claim 4,
wherein a cover plate, which is transparent in at least one optical wavelength range, is used.

6. The method according to Claim 4 or 5,
wherein the cover plate is applied by anodic or eutectic bonding or by glass frit bonding.

7. The method according to one of Claims 1 through 6,
wherein the layers are designed and structured to form a single-axis or multiaxis movable micro-mirror plate (311) as the micro-mirror element.

8. A micro-mirror actuator, which, in an inner area, has at least one movable micro-mirror element and multiple finger-shaped or comb-shaped electrodes for activating the micro-mirror elements, which are offset to one another in height, wherein
- the actuator is formed from a layered construction made of at least three main layers (101, 103, 107), which are at least sectionally electrically insulated from one another via intermediate layers (102, 104, 106),
- the inner area is enclosed by a closed frame (310) made of at least the uppermost layer (107), which allows a hermetic encapsulation of the inner area by application of a cover plate onto the frame (310), and
- a conductor level (105), which is insulated from these main layers via the intermediate layers, is situated between at least two of the main layers, having conductor paths, via which one or more of the electrodes may be electrically contacted from outside the frame (310) via contact openings in one or more of the intermediate layers (102, 104, 106).

9. The micro-mirror actuator according to Claim 8,
wherein the micro-mirror element is a single-axis or multiaxis movable micro-mirror plate (311).

10. The micro-mirror actuator according to Claim 8 or 9,
wherein a cover plate is applied hermetically sealed onto the frame (310).

11. The micro-mirror actuator according to Claim 10,
wherein the cover plate is transparent in at least one optical wavelength range.

## Revendications

1. Procédé pour la fabrication d'un actionneur de micro-miroirs comportant au moins un élément mobile de micro-miroir dans une région interne, ainsi que plusieurs électrodes en forme de doigts ou de peignes pour l'activation de l'élément de micro-miroir, lesquelles sont décalées en hauteur les unes par rapport aux autres,
dans lequel est fabriquée une structure en couches composée d'au moins trois couches principales (101, 103, 107) électriquement isolées au moins par endroits les unes des autres par des couches intermédiaires (102, 104, 106), et dans lequel les couches sont conçues et structurées pour former l'élément de micro-miroir et les électrodes,
dans lequel la structuration des couches est réalisée de manière à obtenir un cadre fermé (310) au moins à partir de la couche principale supérieure (107), lequel entoure la région interne de l'actionneur et permet un enrobage hermétique de la région interne par application d'une plaque couvrante sur le cadre (310), et dans lequel, lors de la réalisation de la structure en couches, un plan de pistes conductrices (105) électriquement isolé des couches principales par les couches intermédiaires est réalisé entre au moins deux des couches principales et structuré pour former des pistes conductrices, des ouvertures de contact sont formées, et une ou plusieurs électrodes peuvent être mises en contact électrique depuis l'extérieur du cadre (310), par les pistes conductrices, après la formation des ouvertures de contact dans une ou plusieurs des couches intermédiaires (102, 104, 106).

2. Procédé selon la revendication 1,
dans lequel une face supérieure du cadre (310) est polie après la structuration.

3. Procédé selon la revendication 1 ou 2,
dans lequel la fabrication sur un plan de pastille est réalisée en fabriquant la structure en couches pour une multitude d'actionneurs de micro-miroirs agencés côte à côte, sur une pastille formant l'une des couches principales.

4. Procédé selon la revendication 3,
dans lequel, après la structuration, une nouvelle pastille (108) ou un substrat de la taille d'une pastille est appliqué(e) en tant que plaque couvrante sur la structure en couches et relié(e) de façon hermétique et étanche au cadre (310) des actionneurs de micro-miroirs agencés côte à côte.

5. Procédé selon la revendication 4,
dans lequel est utilisée une plaque couvrante, qui est transparente dans au moins une plage optique de longueur d'onde.

6. Procédé selon la revendication 4 ou 5,
dans lequel la plaque couvrante est appliquée par fixation eutectique ou anodique, ou par fixation par frittes de verre.

7. Procédé selon l'une des revendications 1 à 6,
dans lequel les couches pour la formation d'une plaque de micro-miroir (311) mobile à un ou plusieurs axes sont conçues et structurées comme élément de micro-miroir.

8. Actionneur de micro-miroir comportant au moins un élément mobile de micro-miroir dans une région interne, ainsi que plusieurs électrodes en forme de doigts ou de peignes pour l'activation de l'élément de micro-miroir, lesquelles sont décalées en hauteur les unes par rapport aux autres, dans lequel
- l'actionneur est constitué d'une structure en couches composée d'au moins trois couches principales (101, 103, 107) électriquement isolées au moins par endroits les unes des autres par des couches intermédiaires (102, 104, 106),
- la région interne est entourée par au moins un cadre fermé (310) constitué au moins de la couche principale supérieure (107), lequel permet d'obtenir un enrobage hermétique de la région interne par application d'une plaque couvrante sur le cadre (310), et
- un plan de pistes conductrices (105) électriquement isolé des couches principales par les couches intermédiaires est agencé entre au moins deux des couches principales, avec des pistes conductrices par lesquelles une ou plusieurs électrodes peuvent être mises en contact électrique depuis l'extérieur du cadre (310), par des ouvertures de contact dans une ou plusieurs des couches intermédiaires (102, 104, 106).

9. Actionneur de micro-miroir selon la revendication 8, dans lequel l'élément de micro-miroir est une plaque de micro-miroir (311) mobile à un ou plusieurs axes.

10. Actionneur de micro-miroir selon la revendication 8 ou 9, dans lequel une plaque couvrante est appliquée de façon hermétique et étanche sur le cadre (310).

11. Actionneur de micro-miroir selon la revendication 10, dans lequel la plaque couvrante est transparente dans au moins une plage optique de longueur d'onde.
